# EUROPEAN PATENT APPLICATION

(11) **EP 3 647 245 A1**
(43) Date of publication of application: **06.05.2020**
(21) Application number: 18203025.4
(22) Date of filing: 29.10.2018
(51) Int. Cl.: B66B 1/30

(54) **ELEVATOR SYSTEM WITH ENERGY HARVESTING DEVICE PLACED AT THE CAR**

(71) Applicant: Otis Elevator Company, Farmington, Connecticut 06032 (US)
(72) Inventor: Derk Oscar, Pahlke, 13507 Berlin (DE)
(74) Representative: Schmitt-Nilson Schraud Waibel Wohlfrom Patentanwälte Partnerschaft mbB

(57) **Abstract**

An elevator system (2) comprises an elevator car (10) configured for traveling within a hoistway (4) between a plurality of landings (8); and at least one energy harvesting device (20) attached to the elevator car (10). The at least one energy harvesting device (20) is configured for converting mechanical energy, in particular kinetic energy, into electric energy.

## Description

The invention relates to an elevator system, in particular to an elevator system comprising an energy harvesting device mounted to the elevator car and configured for converting mechanical energy, in particular kinetic energy, into electric energy.

Elevator systems typically comprise at least one elevator car moving along a hoistway extending between a plurality of landings. Elevator systems further comprise an elevator drive configured for driving the elevator car. Sensor devices, including for example position and/or speed sensors, may be provided at the elevator car for detecting various parameters such as the current position and/or the current speed of the elevator car. These sensor devices may be configured for wireless transmission of the detected data in order to avoid the need of connecting the elevator car by means of electrical lines with a stationary device, such as an elevator control, provided at or within the hoistway.

For allowing wireless data transmission without wiring, the sensor devices should be powered autonomously, i.e. without requiring a wire connection supplying electrical energy from an external power supply.

It therefore is desirable to provide an elevator car with an efficient and reliable autonomous power supply which may be implemented at low costs.

According to an exemplary embodiment of the invention, an elevator system comprises an elevator car configured for traveling within a hoistway between a plurality of landings, and at least one energy harvesting device provided at the elevator car. The at least one energy harvesting device, which may be attached to the elevator car, is configured for converting mechanical energy, in particular kinetic energy, of the elevator car or components of the elevator car, such as doors of the elevator car, into electric energy.

In an elevator system according to an exemplary embodiment of the invention, electric devices at the elevator car, in particular sensor devices, may be operated without being connected to an external power supply. There in particular is no need for connecting the movable elevator car with a stationary portion of the elevator system by electric wires or other couplings, such as electromagnetic couplings, for supplying electric power to the elevator car. As a result, the installation and maintenance of such an elevator system is considerably simplified, and the costs for installing and maintaining the elevator system are considerably reduced.

Exemplary embodiments of the invention further include an energy harvesting device configured for converting mechanical energy, in particular kinetic energy, into electric energy, wherein the energy harvesting device has the shape of a cylinder, with the outer dimensions of the cylinder corresponding to the outer dimensions of a standard battery cell, in particular of one of an A-battery cell, AA-battery cell and a AAA-battery cell, or any other standardized battery cell.

Such an energy harvesting device allows replacing a standard battery cell in any electric device by an energy harvesting device according to an exemplary embodiment of the invention without redesigning the electric device. As a result, energy harvesting devices according to exemplary embodiments of the invention may be employed as reliable and maintenance-free electric energy supplies in any kind of electric devices, which are regularly accelerated and/or decelerated.

A number of optional features are set out in the following. These features may be realized in particular embodiments, alone or in combination with any of the other features, unless specified otherwise.

The at least one elevator car may comprise at least one movable elevator car door, and the at least one energy harvesting device may be attached to the at least one movable elevator car door. Such a configuration allows harvesting energy from the opening and closing motions the at least one elevator car door.

The at least one energy harvesting device may be a capacitive energy harvesting device comprising at least one piezoelectric element and at least one mass, with the at least one mass being configured for applying a mechanical force to the at least one piezoelectric element when the at least one energy harvesting device is accelerated or decelerated. A capacitive energy harvesting device provides a reliable energy harvesting device including almost no moving parts.

The at least one energy harvesting device may be an inductive energy harvesting device comprising at least one permanent magnet which is movably arranged within at least one electric coil. An inductive electric energy harvesting device provides a reliable energy harvesting device which may be implemented at low costs.

The at least one permanent magnet may be or may comprise a movable element which is movable arranged and supported within a casing, in particular a tubular casing. The movable element may be slideable within the casing. For reducing the friction between the movable element and the casing, the movable element may be a rolling element such as a roller or a ball which is configured for rolling within the casing.

This results in a very simple configuration of the energy harvesting device.

The at least one energy harvesting device may comprise at least one reflector, in particular an elastic reflector, provided at least at one end of the casing and configured for reflecting the movable element element from the at least one end of the casing towards a central portion of the casing. The at least one energy harvesting device in particular may comprise two reflectors provided at two opposing ends of the casing. Providing a reflector at at least one end of the casing supports the movement of the permanent magnet and thereby enhances the efficiency of the energy harvesting device.

At least one elastic element, in particular a spring, such as a spiral spring, may be mounted to the at least one permanent magnet, and the at least one permanent magnet may be movable by compressing and/or expanding the at least one elastic element. Such a configuration provides an energy harvesting device which is very efficient, as the permanent magnet is movable with low or nearly no friction.

The two elastic elements may be mounted to opposing ends of the at least one permanent magnet causing a linear oscillation of the at least one permanent magnet along an axis extending between the two opposing ends.

The at least one permanent magnet may comprise neodymium, it in particular may comprise NdFeB, for providing a strong permanent magnet.

The at least one energy harvesting device may be configured for generating electric energy when moved, in particular when accelerated and/or decelerated, in a horizontal and/or in a vertical direction.

The at least one energy harvesting device in particular may be configured for generating electric energy when it is accelerated and/or decelerated in a vertical direction, as it occurs when the elevator car starts moving or is stopped. Such an energy harvesting device may be attached to the elevator car for generating electrical energy from the vertical movements of the elevator car.

The at least one energy harvesting device also may be configured for generating electric energy when it is accelerated and/or decelerated in a horizontal direction, as it occurs when a (sliding) door of the elevator car is opened and/or closed. Such an energy harvesting device in particular may be attached to a door panel of an elevator car door.

The at least one energy harvesting device may be configured for generating electric energy when it is accelerated and/or decelerated in a horizontal direction and/or in a vertical direction. Such an energy harvesting device may be attached to a door panel of an elevator car door for generating electric energy when either of the panel of the elevator car door and the complete elevator car is moved, in particular accelerated or decelerated.

The at least one energy harvesting device may be electrically connected to an electric circuit, such as a rectifying and storage circuit, comprising an electric rectifier, in particular at least one semiconductor diode, which is configured for rectifying an electric current provided by the energy harvesting device. A rectified (DC) current may be stored more easily than an alternating (AC) current.

The electric circuit may comprise an electric storage device configured for storing the electric energy generated by the at least one energy harvesting device. The electric storage device in particular may comprise a battery, a capacitor, a combination of capacitors, or at least one supercapacitor (supercap).

At least one sensor device, in particular a sensor device comprising a position sensor and/or a speed sensor, may be provided at the at least one elevator car. The at least one sensor device in particular may be part of an elevator safety device. The at least one energy harvesting device may be configured for supplying electric energy to the at least one sensor device. Such a configuration allows operating the at least one sensor device located at the elevator car without connecting the at least one sensor device to an external power supply.

The at least one energy harvesting devicemay have a housing in the shape of a cylinder. The outer dimensions of the cylinder in particular may correspond to the outer dimensions of a standard battery cell, in particular of one of an A-battery cell, AA-battery cell and a AAA-battery cell.

The at least one energy harvesting device also may have a housing in the shape of a coin, in particular a housing corresponding to a standard coin cell battery, such as a CR 2032 battery cell.

An energy harvesting device having such a design may be exchanged easily with a standard battery cell and vice-versa, e.g. in case of failure of the energy harvesting device or for test and/or maintenance purposes.

The applicant considers the idea of providing an energy harvesting device having the shape of a standard battery cell to be an inventive contribution to the art on its own, independently of the idea of combining an energy harvesting device with an elevator car.

In the following, exemplary embodiments of the invention are described in more detail with respect to the enclosed figures:
Figure 1 schematically depicts an elevator system in which an energy harvesting device according to an exemplary embodiment of the invention may be employed.
Figure 2 schematically shows an energy harvesting device according to an exemplary embodiment of the invention.
Figure 3 schematically shows an energy harvesting device according to another exemplary embodiment of the invention.
Figure 4 schematically shows an energy harvesting device according to yet another exemplary embodiment of the invention.
Figure 5 schematically shows an energy harvesting device having the shape of a standard battery cell.
Figure 6 schematically shows an energy harvesting device having the shape of a standard coin cell battery.

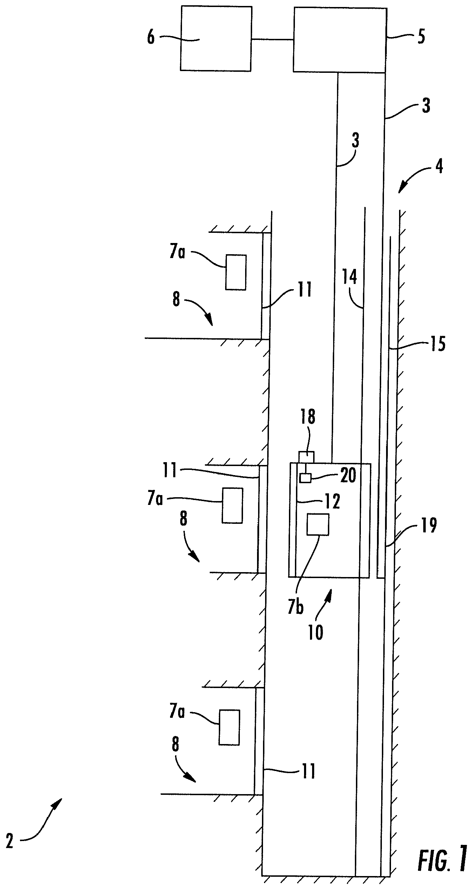

Figure 1 schematically depicts an elevator system 2 in which an elevator brake 20 according to an exemplary embodiment of the invention may be employed.

The elevator system 2 includes an elevator car 10 movably arranged within a hoistway 4 extending between a plurality of landings 8. The elevator car 10 in particular is movable along a plurality of car guide members 14, such as guide rails, extending along the vertical direction of the hoistway 4. Only one of said car guide members 14 is visible in Figure 1.

Although only one elevator car 10 is depicted in Figure 1, the skilled person will understand that exemplary embodiments of the invention may include elevator systems 2 having a plurality of elevator cars 10 moving in one or more hoistways 4.

The elevator car 10 is movably suspended by means of a tension member 3. The tension member 3, for example a rope or belt, is connected to an elevator drive 5, which is configured for driving the tension member 3 in order to move the elevator car 10 along the height of the hoistway 4 between the plurality of landings 8, which are located on different floors.

Each landing 8 is provided with a landing door 11, and the elevator car 10 is provided with a corresponding elevator car door 12 for allowing passengers to transfer between a landing 8 and the interior of the elevator car 10 when the elevator car 10 is positioned at the respective landing 8.

The exemplary embodiment of the elevator system 2 shown in Figure 1 employs a 1:1 roping for suspending the elevator car 10. The skilled person, however, easily understands that the type of the roping is not essential for the invention and that different kinds of roping, e.g. a 2:1 roping, may be used as well. The elevator system 2 may have a machine room or may be a machine room-less elevator system. The elevator system 2 may use a tension member 3, as it is shown in Figure 1, or it may be an elevator system without a tension member 3. The elevator drive 5 may be any form of drive used in the art, e.g. a traction drive, a hydraulic drive or a linear drive.

The elevator system 2 shown in Figure 1 further includes a counterweight 19 attached to the tension member 3 and moving concurrently and in opposite direction with respect to the elevator car 10 along at least one counterweight guide member 15. The skilled person will understand that the invention may be applied also to elevator systems 2 which do not comprise a counterweight 19.

The tension member 3 may be a rope, e.g. a steel wire rope, or a belt. The tension member 3 may be uncoated or may have a coating, e.g. in the form of a polymer jacket. In a particular embodiment, the tension member 3 may be a belt comprising a plurality of polymer coated steel cords (not shown). The elevator system 2 may have a traction drive including a traction sheave for driving the tension member 3.

The elevator drive 5 is controlled by an elevator control 6 for moving the elevator car 10 along the hoistway 4 between the different landings 8.

Input to the elevator control 6 may be provided via landing control panels 7a, which are provided on each landing 8 in the vicinity the landing doors 11, and/or via an elevator car control panel 7b provided inside the elevator car 10.

The landing control panels 7a and the elevator car control panel 7b may be connected to the elevator control 6 by means of electric wires, which are not shown in Figure 1, in particular by an electric bus, such as a field bus / CAN-bus, or by means of wireless data connections.

The elevator car 10 is equipped with a sensor device 18, which for example may include a position sensor and/or a speed sensor configured for detecting the position and/or the speed of the elevator car 10, respectively. In one embodiment, the sensor device 18 may be located at any desired location in the hoistway 4 or on the elevator equipment.

The sensor device 18 may be configured for wireless data transmission in order to allow transmitting data from the sensor device 18 to the elevator control 6 without providing a wire connection between the sensor device 18 and the elevator control 6.

The elevator car 10 is further equipped with an energy harvesting device 20. The energy harvesting device 20 is configured for generating electric energy, which is supplied to the sensor device 18 in order to allow operating the sensor device 18 without connecting the sensor device 18 to an external power supply.

The harvesting device 20 in particular is configured for converting kinetic energy of the elevator car 10 and/or kinetic energy of the elevator car door 12 into electric energy. In one embodiment, the harvesting device 20 may be located at any desired location in the hoistway 4 or on the elevator equipment.

The energy harvesting device 20 allows operating the sensor device 18 without running an electric cable to the sensor device 18 for delivering electric power to the sensor device 18. In contrast to conventional batteries, an energy harvesting device 20 according to an exemplary embodiment of the invention does not run out of power but has a long lifetime. In consequence, the need for maintenance is considerably reduced.

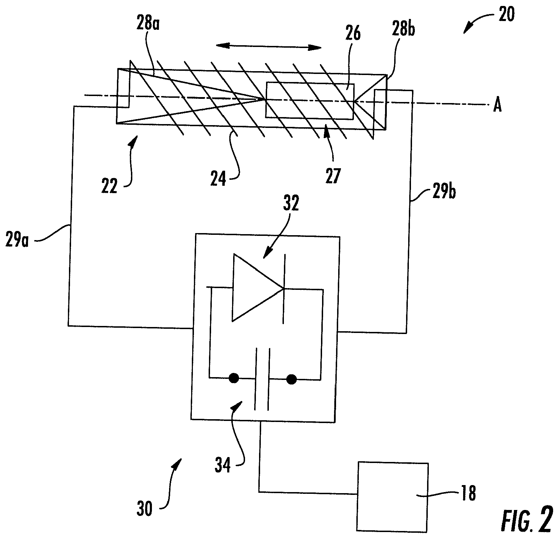

Figure 2 schematically shows an energy harvesting device 20 according to an exemplary embodiment of the invention.

The energy harvesting device 20 comprises a movable element 27 including a permanent magnet 26 arranged in a cylindrical electric coil 24. For providing a strong permanent magnet, the permanent magnet 26 may comprise neodymium, it in particular may comprise NdFeB.

The movable element 27 is supported by two elastic elements 28a, 28b, such as springs, in particular spiral springs, allowing the movable element 27 to move, in particular to oscillate, in a linear motion along a central axis A of the cylindrical electric coil 24 by alternatingly compressing and expanding the elastic elements 28a, 28b.

The movable element 27 and the elastic elements 28a, 28b may be accommodated in a casing 22 in order to be protected from external influences. The casing 22 in particular may have the shape of a tube, in particular a cylindrical tube, extending along the central axis A through the center of the electric coil 24.

The ends of the cylindrical coil 24 are electrically connected by electric wires 29a, 29b to a rectifying and storage circuit 30.

The rectifying and storage circuit 30 comprises an electric rectifier 32, which may include at least one semiconductor diode, and a storage device 34 including a capacitor, a combination of capacitors and/or at least one supercap.

When the energy harvesting device 20 is accelerated or decelerated along the central axis A of the electric coil 24, the movable element 27 starts to move relatively to the electric coil 24 due to its inertia. In combination with the elastic forces provided by the elastic elements 28a, 28b, which are deformed (compressed or expanded) by the movement of the movable element 27, the movable element 27 starts oscillating along the axial direction, the permanent magnet 26 inducing an oscillating electric voltage within the electric coil 24.

The induced electric voltage causes an electric current to flow through the electric wires 29a, 29b connected to the ends of the electric coil 24. Said electric current is rectified by the electric rectifier 32 and stored within the storage device 34.

The electric energy stored within the storage device 34 may be supplied to the sensor device 18 for operating the sensor device 18.

In an energy harvesting device 20 according to an exemplary embodiment of the invention, the storage device 34 is charged with electric energy every time the elevator car 10 is accelerated or decelerated.

The energy harvesting device 20 may be attached to the elevator car 10 in a configuration in which the central axis A of the electric coil 24 is oriented in a vertical direction in order to allow for an efficient conversion of the mechanical energy of the vertically moving elevator car 10.

Alternatively or additionally, an energy harvesting device 20 according to an exemplary embodiment of the invention may be attached to the elevator car door 12, in particular to a panel of the elevator car door 12, in a configuration in which the central axis A of the electric coil 24 is oriented in a horizontal direction for converting the mechanical energy of the (horizontally) moving elevator car door 12 when the elevator car door 12 is opened and/or closed. In one embodiment, the energy harvesting device 20 may be attached to the counterweight 19 or any other moving portion of the elevator system.

In another configuration, the central axis A of the electric coil 24 may be oriented diagonally in order to allow converting mechanical energy of the vertically moving elevator car 10 as well as mechanical energy of the horizontally moving panel(s) of the elevator car door 12.

In yet another configuration, the movable element 27 may be supported, e.g. by a plurality of elastic elements 28a, 28b, such that it is movable in two or three dimensions.

The energy harvesting device 20 is configured so that sufficient electric energy is generated and stored in the course of normal operation of the elevator system 2. As a result, the sensor device 18 may be operated continuously without supplying external electric power to the sensor device 18 or to the storage device 34.

In consequence, the sensor device 18 may be operated over the lifetime of the elevator system 2 without externally recharging the storage device 34. As a result, the energy harvesting device 20 does not considerably contribute to the costs for maintaining the elevator system 2.

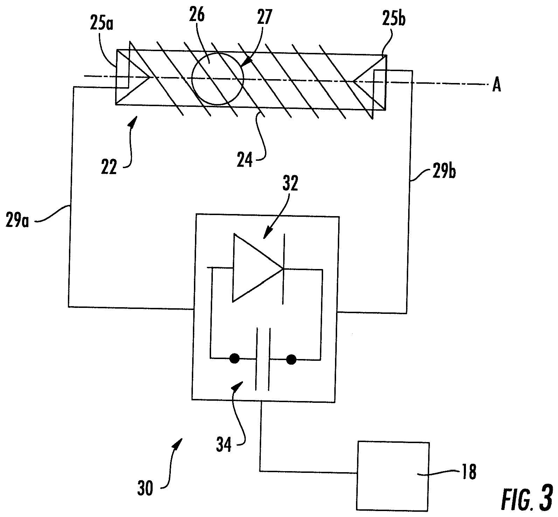

Figure 3 schematically depicts an alternative exemplary embodiment of an energy harvesting device 20.

In the embodiment depicted in Figure 3, the movable element 27 including the permanent magnet 26 has the shape of a rolling element, such as a roller or a ball, which is rollably supported within the casing 22. The casing 22 in particular may be formed as a tube. Two reflectors 25a, 25b, in particular elastic reflectors 25a, 25b, are provided at the ends of the casing 22 and configured for reflecting the movable element 27 from the ends towards the center of the casing 22.

As in the embodiment depicted in Figure 2, the casing 22 is surrounded by an electric coil 22, which is electrically connected via electric wires 29a, 29b to a rectifying and storage circuit 30. The rectifying and storage circuit 30 corresponds to the rectifying and storage circuit 30 depicted in Figure 2, therefore it is not discussed in detail again.

When the casing 22 is accelerated or decelerated along the central axis A of the electric coil 24, the movable element 27 starts moving and oscillating between the two reflectors 25a, 25b causing the permanent magnet 26 to induce an (oscillating) electric voltage within the electric coil 24, as it has been described with reference to the embodiment depicted in Figure 2.

The embodiment depicted in Figure 3 is well suited for a horizontal orientation of the casing 22, in particular for an energy harvesting device 20 attached to the horizontally moving panel(s) of the elevator car door 12.

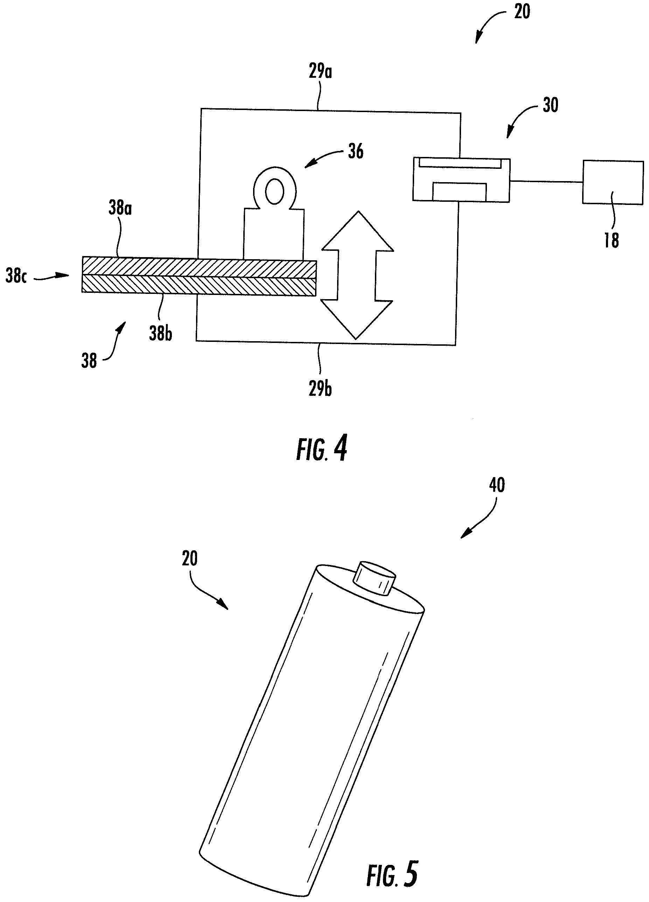

Figure 4 schematically depicts yet another exemplary embodiment of an energy harvesting device 20.

The energy harvesting device 20 depicted in Figure 4 comprises a piezoelectric element 38 and a mechanical mass 36 mechanically connected to or formed integrally with the piezoelectric element 38.

The piezoelectric element 38 comprises two electrodes 38a, 38b and a piezoelectric layer 38c sandwiched between the two electrodes 38a, 38b.

When the mechanical mass 36 is accelerated or decelerated, e.g. since the elevator car 10 and/or a panel of the elevator car door 12 is accelerated or decelerated, the inertia of the mass 36 causes the piezoelectric layer 38c to compress or to expand. Compression and expansion of the piezoelectric layer 38c generate an electric voltage between the two electrodes 38a, 38b.

Said electric voltage causes an electric current to flow within the electric wires 29a, 29b connected to the electrodes 38a, 38b. Said electric current is supplied to a rectifying and storage circuit 30 from where it is delivered to the sensor device 18, as it has been described for the previous exemplary embodiments depicted in Figures 2 and 3.

An energy harvesting device 20 comprising a piezoelectric element 38 may be mounted to the elevator car 10 in any orientation, in particular including a vertical orientation, which is beneficial for being activated by vertical acceleration and deceleration of the elevator car 10, a horizontal orientation, which is beneficial for being activated by horizontal acceleration and deceleration of elevator car door panels, and a diagonal orientation, which allows activating the piezoelectric element 38 by both, vertical and horizontal acceleration and deceleration.

Although only one energy harvesting device 20 is depicted in Figure 1, the skilled person understands that a plurality of energy harvesting devices 20 may arranged at the same elevator car 10. In particular, in case of a plurality of sensor devices 18, each sensor device 18 may be provided with its own energy harvesting device 20 in order to allow for an autonomous operation of the respective sensor device 18. Further, each sensor device 18 may be provided with two or more energy harvesting devices 20 in order to enhance the operational safety of the sensor device 18 due to redundancy.

For clarity of illustration, the depiction of the rectifying and storage circuit 30 in Figures 2 to 4 is not on scale. The skilled person understands that the rectifying and storage circuit 30 usually is much smaller than depicted in Figures 2 to 4. The rectifying and storage circuit 30 in particular may be integrated with the casing 22 and/or the electric coil 24 for forming a compact energy harvesting device 20.

The energy harvesting device 20 may be designed as a cylinder having outer dimensions corresponding to the outer dimensions of a standard battery cell 40 as it is depicted in Figure 5. The energy harvesting device 20 in particular may have the dimensions of one of an A-battery cell, AA-battery cell and a AAA-battery cell, or any other standardized battery cell.

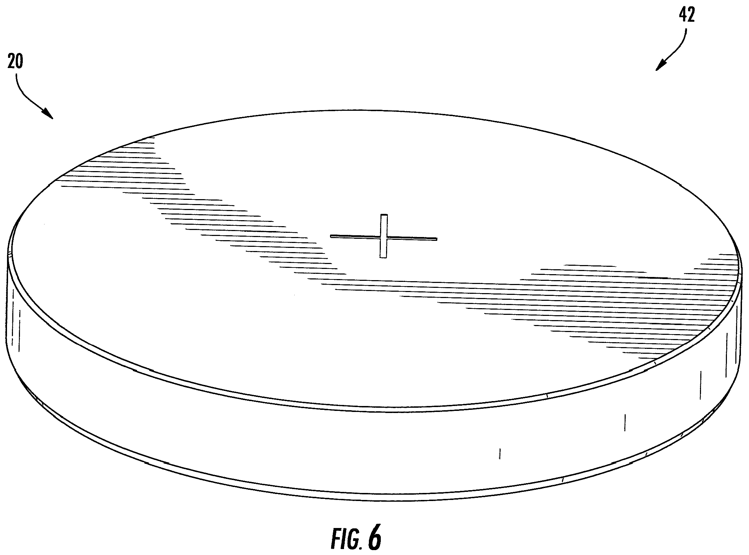

Alternatively, the energy harvesting device 20 may be designed as a coin cell battery 42, such as a CR2032 coin cell battery 42. An example of a coin cell battery 42 is depicted in Figure 6.

Such a design allows replacing a standard battery cell 40 in any electric device by an energy harvesting device 20 according to an exemplary embodiment of the invention without redesigning the electric device.

The use of energy harvesting devices 20 according to exemplary embodiments of the invention is not restricted to elevator systems 2. Instead, energy harvesting devices 20 according to exemplary embodiments of the invention may be employed as reliable and maintenance-free electric energy supplies for any kind of electric devices which are regularly accelerated and/or decelerated.

While the invention has been described with reference to exemplary embodiments, it will be understood by those skilled in the art that various changes may be made and equivalents may be substituted for elements thereof without departing from the scope of the invention. In addition, many modifications may be made to adopt a particular situation or material to the teachings of the invention without departing from the essential scope thereof. Therefore, it is intended that the invention shall not be limited to the particular embodiment disclosed, but that the invention includes all embodiments falling within the scope of the dependent claims.

### References

- 2: elevator system
- 3: tension member
- 4: hoistway
- 5: drive
- 6: elevator control
- 7a: landing control panel
- 7b: elevator car control panel
- 8: landing
- 10: elevator car
- 11: landing door
- 12: elevator car door
- 14: car guide member
- 15: counterweight guide member
- 19: counterweight
- 20: energy harvesting device
- 22: casing
- 24: electric coil
- 25a, 25b: reflectors
- 26: permanent magnet
- 27: movable element
- 28a, 28b: elastic elements
- 29a, 29b: electric wires
- 30: rectifying and storage circuit
- 32: electric rectifier
- 34: storage device
- 36: mass
- 38: piezoelectric elements
- 38a, 38b: electrodes
- 38c: piezoelectric layer
- 40: battery cell

## Claims

1. Elevator system (2) comprising:
an elevator car (10) configured for traveling within a hoistway (4) between a plurality of landings (8); and
at least one energy harvesting device (20) provided at the elevator car (10);
the at least one energy harvesting device (20) is configured for converting mechanical energy, in particular kinetic energy, into electric energy.

2. Elevator system (2) according to claim 1, wherein the at least one elevator car (10) comprises at least one movable elevator car door (12), and wherein the at least one energy harvesting device (20) attached to the at least one movable elevator car door (12).

3. Elevator system (2) according to claim 1 or 2, wherein the at least one energy harvesting device (20) is a capacitive energy harvesting device (20) comprising at least one piezoelectric element (38).

4. Elevator system (2) according to claim 1 or 2, wherein the at least one energy harvesting device (20) is an inductive energy harvesting device (20) comprising at least one permanent magnet (26) movably arranged within at least one electric coil (24).

5. Elevator system (2) according to claim 4, wherein the at least one permanent magnet (26) is or is comprised in a movable element (27), in particular a rolling element, movably arranged within a casing (22).

6. Elevator system (2) according to claim 5, wherein the at least one energy harvesting device (20) comprises at least one reflector (25a, 25b), in particular at least one elastic reflector (25a, 25b), provided an end of the casing (22) and configured for reflecting the movable element (27) towards a central portion of the casing (22).

7. Elevator system (2) according to claim 4 to 6, wherein at least one elastic element (28a, 28b), in particular a spring, is mounted to the at least one movable element (27), and the at least one movable element (27) is movable by compressing and/or expanding the at least one elastic element (28a, 28b).

8. Elevator system (2) according to claim 7 comprising two elastic elements attached to opposing ends of the at least one movable element (27).

9. Elevator system (2) according to any of claims 4 to 8, wherein the at least one permanent magnet (26) comprises neodymium.

10. Elevator system (2) according to any of the preceding claims, wherein the at least one energy harvesting device (20) is configured for generating electric energy when moved, accelerated and/or decelerated in a horizontal and/or in a vertical direction.

11. Elevator system (2) according to any of the preceding claims, wherein the at least one energy harvesting device (20) is electrically connected to an electric circuit (30) comprising at least one electric rectifier (32), in particular at least one semiconductor diode.

12. Elevator system (2) according to claim 11, wherein the electric circuit (30) comprises an electric storage device (34) configured for storing the electric energy generated by the at least one energy harvesting device (20).

13. Elevator system (2) according to any of the preceding claims, wherein the at least one elevator car (10) comprises at least one sensor device (18), and wherein the at least one energy harvesting device (20) is configured for supplying electric energy to the at least one sensor device (18).

14. Elevator system (2) according to any of the preceding claims, wherein the at least one energy harvesting device (20) has the shape of a cylinder with outer dimensions corresponding to the outer dimensions of a standard battery cell (40), in particular of one of an A-battery cell, AA-battery cell and a AAA-battery cell.

15. Energy harvesting device (20) configured for converting mechanical energy, in particular kinetic energy, into electric energy, wherein the at least one energy harvesting device (20) has the shape of a cylinder or a coin, with outer dimensions of the at least one energy harvesting device (20) corresponding to the outer dimensions of a coin cell battery (42) or of a standard battery cell (40), in particular of one of an A-battery cell, a AA-battery cell, and a AAA-battery cell.
